## Europäisches Patentamt

## European Patent Office

## Office européen des brevets

(11) Veröffentlichungsnummer: **0 197 198**
**B1**

(12) **EUROPÄISCHE PATENTSCHRIFT**

(45) Veröffentlichungstag der Patentschrift:
02.08.89

(21) Anmeldenummer: 85115481.5

(22) Anmeldetag: 05.12.85

(51) Int. Cl.⁴: **H01L 21/76, H01L 21/82,**
**H01L 27/08**

(54) Verfahren zum Herstellen einer die aktiven Bereiche einer hochintegrierten CMOS-Schaltung trennenden Isolation.

(30) Priorität: 13.12.84 DE 3445527

(43) Veröffentlichungstag der Anmeldung:
15.10.86 Patentblatt 86/42

(45) Bekanntmachung des Hinweises auf die Patenterteilung:
02.08.89 Patentblatt 89/31

(84) Benannte Vertragsstaaten:
AT DE FR GB IT NL

(56) Entgegenhaltungen:
EP-A- 0 085 168
DE-A- 3 019 826
FR-A- 2 533 749
US-A- 4 435 896

IEEE Transactions on Electron Devices, vol. ED-29,
April 1982, Seiten 541-547

(73) Patentinhaber: Siemens Aktiengesellschaft Berlin und München, Wittelsbacherplatz 2, D-8000 München 2(DE)

(72) Erfinder: Beinvogl. Willy, Dr., Mallnitzer Strasse 16, D-8000 München 21(DE)

ACTORUM AG

**Beschreibung**

Die Erfindung betrifft ein Verfahren zum Herstellen einer die aktiven Bereiche einer Schaltung trennenden Isolation in einem für die Herstellung von CMOS-Schaltungen in VLSI-Technik (= very large scale integration) vorgesehenen Siliziumsubstrat.

Es gibt mehrere Möglichkeiten, die in integrierten Schaltungen vorhandenen aktiven Bereiche, zum Beispiel Transistoren, voneinander elektrisch zu isolieren. Die bekannteste ist die sogenannte LOCOS (= local oxidation of silicon)-Technik, bei der mit Hilfe einer Oxidationsmaske, zum Beispiel aus Siliziumnitrid, die Isolationsbereiche thermisch oxidiert werden. Nähere Einzelheiten sind aus einem Aufsatz von Appels et. al. in den Philips Research Reports, Vol. 26, Nr. 3, Juni 1971, auf den Seiten 157 bis 165 zu entnehmen.

Es ist sehr schwierig, mit einer Standard-LOCOS-Technik Isolationsstege kleiner, 1,5 µm zu erzeugen, da sich durch eine starke laterale Unteroxidation der sogenannte LOCOS-Schnabel ausbildet und eine starke laterale Ausdiffusion der Feldimplantation, welche eine starke Weitenabhängigkeit der Einsatzspannung schmaler Transistoren zur Folge hat, stattfindet. In dem Aufsatz von Appels wird ein Verfahren beschrieben, bei dem die Form des sogenannten Vogelschnabels (birds beak) weitgehend dadurch bestimmt wird, daß zum Beispiel gezielt Unterätzungen bei der Strukturierung der zuerst als Diffusions-, dann als Oxidationsmaske dienenden Siliziumnitrid/SiO$_2$-Schicht angestrebt werden. Die so hergestellten Feldoxide weisen aber noch viele Kristalldefekte auf, welche die elektrischen Parameter der daraus gefertigten Bauelemente erheblich stören. Weitere Schwierigkeiten ergeben sich bei der lithographischen Auflösung und bei der Siliziumnitridätzung.

Um diese Grenzen der LOCOS-Technologie zu entschärfen, sind mehrere modifizierte LOCOS-artige Verfahren vorgeschlagen worden.

So ist aus einem Aufsatz von. I. Hui et. al. aus dem IEDM Technical Digest 1982 auf den Seiten 220 bis 223 ein Verfahren bekannt, bei dem durch die sogenannte SILO (= sealed interface local oxidation)-Technik durch eine Sandwichstruktur, bestehend aus durch Plasmaerzeugtem Siliziumnitrid, LPCVD (= low pressure chemical vapor deposition)-Oxid und LPCVD-Nitrid die Kristalldefekte beseitigt und die elektrischen Parameter verbessert werden.

Ein weiteres Verfahren dieser Art wird in einem Aufsatz von K. Y. Chiu et. al. in der gleichen Literatur auf den Seiten 224 bis 227 beschrieben. Hier wird die sogenannte SWAMI (= side wall masked isolation)-Technik angewandt, die darauf beruht, daß Spannungen in den Maskierungsschichten durch gezieltes schräges Abätzen und anschließendes Bedecken mit den Maskierungsschichten ausgeglichen werden. Auch durch die eben beschriebenen Verfahren ist eine subµm-Isolation nicht zu erreichen.

Prinzipiell geeignet für eine solche Isolation ist die sogenannten Grabentechnik, welche in der US-PS 4.139.442 ausführlich beschrieben ist. Sie ist jedoch technologisch sehr aufwendig und erfordert zusätzliche Maskierungsprozesse.

Aus einem Aufsatz von Wang et. al. in dem IEEE Transaction on Electron Devices, Vol. ED-29, Nr. 4, April 1982, Seiten 541 bis 547 ist eine Grabenätztechnik zur Isolation von VLSI-Schaltungen als Direct-Moat-Technologie bekannt, bei der die aktiven Bereiche einer Schaltung durch Freiätzen von Bereichen in einer ganzflächig aufgebrachten Isolationsschicht definiert werden.

Die Erfindung geht bei der Lösung der Aufgabe der Herstellung von CMOS-Schaltungen in VLSI-Technik von der wesentlich schmälere Isolationsstege liefernden Direct-Moat-Technik aus und weist die folgenden Verfahrensschritte auf:

a) Herstellen von n-Wannenbereichen im Substrat durch Ionenimplantation von Phosphor- oder Arsen-Ionen nsch Maskierung der übrigen Bereiche des Substrats und Eindiffusion der implantierten Ionen,

b) Durchführung einer Oxidation nach Entfernung der Implantationsmaske,

c) Herstellen von p-Wannenbereichen durch eine zum Beispiel aus Bor-Ionen bestehende Implantation mit einer derart gewählten Dosis und Energie, daß die p-Wannenbereiche eine geringere Eindringtiefe aufweisen als die n-Wannenbereiche,

d) ganzflächige Siliziumnitridabscheidung und Strukturierung der Nitridschicht so, daß die n-Wannenbereiche bis auf die p-Wannenbereiche überlappenden, Bereiche der n-Wannenkanten abgedeckt sind und in den p-Wannenbereichen die aktiven Bereiche dadurch definiert werden, daß nur die Bereiche freigeätzt werden, in denen die Feldimplantation durchgeführt wird,

e) Durchführung der Feldimplantation mir Bor-Ionen,

f) Herstellen der Feldoxidbereiche in den p-Wannenbereichen und den die p-Wannenbereiche überlappenden Bereiche den n-Wannenkanten durch LOCOS-Technik unter Verwendung der Siliziumnitridschicht als Maskierung,

g) Entfernen der Siliziumnitridmaskierung und

h) Freilegen und voneinander Isolieren der aktiven Bereiche in den n-Wannenbereichen, die minimale Isolationsstege benötigen, durch Ätzung von Trenngräben in der Oxidschicht nach vorheriger Maskierung der p-Wannenbereiche und der übrigen Bereiche mit einer Fotolackschicht, wobei zuerst ein Trockenätzprozeß und anschließend ein Naßätzprozess durchgeführt wird.

Die Vorteile des Verfahrens nach der Lehre der Erfindung sind folgende:

1. Die Grabenätzung ist prinzipiell in der Lage, wesentlich schmälere Isolationsstege zu liefern als die LOCOS-Technik. Deshalb wird sie an den Stellen benutzt, wo minimale Isolationsstege benötigt werden, zum Beispiel im Zellenfeld eines DRAMs (= dynamic random access memory). Lithographie- und Ätztoleranzen im Herstellungsprozeß, zum Beispiel durch Überbelichtung bzw. Unterätzung, führen beim LOCOS-Verfahren zu einer Verkleinerung der aktiven Bereiche, bei der Grabenätzung aber zu einer Vergrößerung der aktiven Bereiche. Auf diesem Effekt beruht die Erfindung.

2. Da die Isolation durch die Grabenätzung nur in der n-Wanne benutzt wird, kann man dort mit wesentlich geringeren Feldoxiddicken auskommen (selbstisolierender Effekt). Man hat also in der Prozeßfolge zwei verschiedene Feldoxiddicken zur Verfügung. Die topographischen Probleme an den Isolationskanten in der n-Wanne sind durch die verringerte Oxiddicke merklich entschärft.

3. Es wird keine Zusatzmaske benötigt.

Zur Entschärfung der Isolationskante in den Bereichen der Grabenätzung können mehrere Ätzverfahren benutzt werden; als besonders vorteilhaft hat sich ein kombinierter Trocken-/Naßätzprozeß erwiesen, bei dem zuerst ein Trockenätzen zum Beispiel in Trifluormethan und Sauerstoff ($CHF_3 + O_2$) und anschließend ein Naßätzen in gepufferter Flußsäure durchgeführt wird.

Weitere Einzelheiten der Erfindung werden anhand eines Ausführungsbeispiels dargelegt, welches sich auf die Grabenätzung in der n-Wanne eines CMOS-Prozesses bezieht und in den Figuren 1 bis 7 näher beschrieben ist. Dabei zeigen

die Figuren 1 bis 5 im Schnittbild Anordnungen, denen die einzelnen Stadien bei der Herstellung der Isolation zu entnehmen sind und

die Figuren 6 und 7 zwei vorteilhafte Ätzstrukturen.

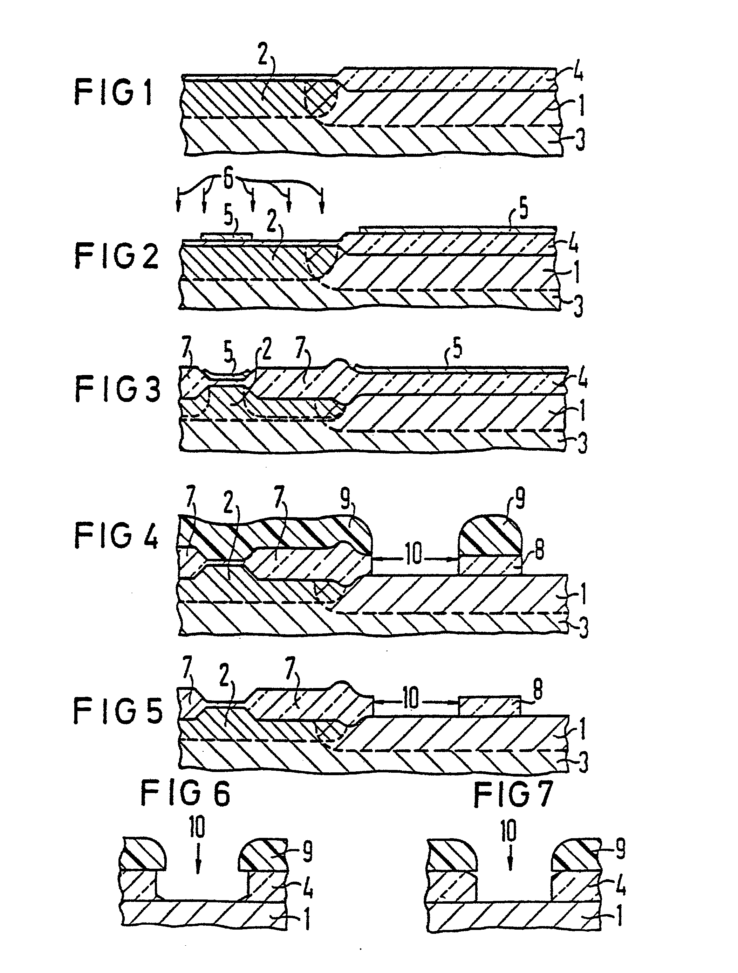

Figur 1 zeigt die Anordnung nach dem Herstellen der n-Wanne 1 und der p-Wanne 2 in einem Siliziumsubstrat 3 und nach dem Erzeugen der über der n-Wanne 1 liegenden Oxidschicht 4. Die n-Wanne wird durch Phosphor-Ionenimplantation nach Maskierung der übrigen Bereiche des Substrats 1 und Eindiffusion der implantierten Ionen (zum Beispiel 3 μm) hergestellt; die p-Wanne 2 wird erzeugt durch eine zum Beispiel aus Bor-Ionen bestehende Implantation.

Figur 2: Eine ganzflächiges Siliziumnitrid-Abscheidung 5 wird so strukturiert, daß der n-Wannenbereich 1, in welchem die Grabenisolation durchgeführt werden soll, abgedeckt ist und im p-Wannenbereich 2 die Feldimplantation mit Bor-Ionen 6 durchgeführt werden kann. Die Gebiete über der n-Wannenkante (1) werden auch geöffnet.

Figur 3: Im p-Wannenbereich 2 werden dann unter Verwendung der Siliziumnitridmaske 5 die Feldoxidbereiche 7 mittels lokaler Oxidation hergestellt.

Figur 4: Nach Entfernung der Siliziumnitridmaskierung 5 durch zum Beispiel heiße Phosphorsäure werden die aktiven Bereiche in der n-Wanne 1 durch Grabenätzung 10 definiert. Dabei wird der p-Wannenbereich 2 und die als Isolationsstege 8 dienende Oxidschicht 4 mit einer Fotolackmaske 9 abgedeckt. Die Ätzung erfolgt in zwei Schritten:

a) anisotrope Trockenätzung; die letzten ca. 30 - 50 nm der $SiO_2$-Schicht werden

b) naßchemisch, zum Beispiel in gepufferter Flußsäure entfernt. Dadurch wird das Siliziumsubstrat, auf dem später aktive Elemente, zum Beispiel Speicherzellen entstehen, nicht einem Trockenätzprozeß ausgesetzt.

Figur 5 zeigt die nach dem erfindungsgemäßen Verfahren hergestellte Anordnung nach Entfernung der Fotolackmaske 9. Es gelten die gleichen Bezugszeichen wie in Figur 4. Ein wesentlicher Bestandteil dieser Prozeßführung ist die Tatsache, daß bei geeigneter Wannendotierung eine Feldimplantation (zum Beispiel Phosphor) in den n-Wannenbereich 1 unterbleiben kann, da wegen des pileup-Effekts während der Feldoxidation 4 die nötige Oberflächendotierung des parasitären n-Kanal-Transistors entsteht. Die so hergestellte Struktur wird nach bekannten Verfahrensschritten der CMOS-Technologie weiterverarbeitet.

In Figur 6 ist eine Ätztruktur dargestellt, bei der zuerst eine Trocken- und dann eine Naßätzung erfolgt ist. Diese Variante hat den Vorteil, daß eine eventuelle Substratschädigung durch Trockenätzen verhindert wird.

In Figur 7 ist die umgekehrte Reihenfolge durchgeführt worden. Diese Variante bietet den Vorteil, daß die Breite der Isolationsstege geringeren Toleranzen unterliegt als bei der Variante aus Figur 6. Das Problem der Substratschädigung erfordert hier jedoch eine kompliziertere Prozeßführung, zum Beispiel Hilfsoxidationen. Beide Verfahren können miteinander kombiniert angewandt werden.

**Patentansprüche**

1. Verfahren zum Herstellen einer CMOS-Schaltung mit in einem p-dotierten Substrat (3) enthaltenen, einen unterschiedlichen Leitungstyp aufweisenden Wannenbereichen (1, 2) mit den folgenden Verfahrensschritten

a) Herstellen von n-Wannenbereichen im Substrat (3) durch Ionenimplantation von Phosphor- oder Arsen-Ionen nach Maskierung der übrigen Bereiche des Substrats (3) und Eindiffusion der implantierten Ionen,

b) Durchführung einer Oxidation (4) nach Entfernung der Implantationsmaske,

c) Herstellen von p-Wannenbereichen (2) durch eine zum Beispiel aus Bor-Ionen bestehende Implantation mit einer derart gewählten Dosis und Energie, daß die p-Wannenbereiche (2) eine geringere Eindringtiefe aufweisen als die n-Wannenbereiche (1),

d) ganzflächige Siliziumnitridabscheidung (5) und Strukturierung der Nitridschicht (5) so, daß die n-Wannenbereiche (1) bis auf die, die p-Wannenbereiche (2) überlappenden, Bereiche der n-Wannenkanten abgedeckt sind und in den p-Wannenbereichen (2) die aktiven Bereiche dadurch definiert werden, daß nur die Bereiche freigeätzt werden, in denen die Feldimplantation (6) durchgeführt wird,

e) Durchführung der Feldimplantation (6) mit Bor-Ionen,

f) Herstellen der Feldoxidbereiche (7) in den p-Wannenbereichen (2) und den die p-Wannenbereiche (2) überlappenden Bereiche der n-Wannenkanten durch LOCOS-Technik unter Verwendung der Siliziumnitridschicht (5) als Maskierung,

g) Entfernen der Siliziumnitridmaskierung (5) und

h) Freilegen und voneinander Isolieren der aktiven Bereiche in den n-Wannenbereichen (1), die minimale Isolationsstege (8) benötigen, durch Ätzung von Trenngräben (10) in der Oxidschicht (4) nach vorheriger Maskierung der p-Wannenbereiche (2) und der übrigen Bereiche mit einer Fotolackschicht (9), wobei zuerst ein Trockenätzprozeß und anschließend ein Naßätzprozeß durchgeführt wird.

2. Verfahren nach Anspruch 1, wobei im Verfahrensschritt h) der Trockenätzprozeß in Trifluormethan und Sauerstoff (CHF₃ + O₂) und der Naßätzprozeß in gepufferter Flußsäure durchgeführt wird.

## Claims

1. Method for producing a CMOS circuit with tub regions (1, 2) contained in a p-doped substrate (3) and exhibiting a different type of conduction, with the following method steps:

a) production of n-type tub regions in the substrate (3) by ion implantation of phosphorus or arsenic ions after masking the remaining regions of the substrate (3) and diffusing the implanted ions,

b) carrying out of an oxidation (4) after removal of the implantation mask,

c) production of p-type tub regions (2) by an implantation, consisting, for example, of boron ions, with a dosage and energy which is selected in such a manner that the p-type tub regions (2) exhibit a lesser depth of penetration than the n-type tub regions (1),

d) silicon nitride deposition (5) over the entire surface and structuring of the nitride layer (5) in such a manner that the n-type tub regions (1) are covered apart from the regions of the n-type tub edges overlapping the p-type tub regions (2) and the active regions in the p-type tub regions (2) are defined by the fact that only the regions in which the field implantation (6) is being carried out are etched free,

e) carrying out of the field implantation (6) with boron ions,

f) production of the field oxide regions (7) in the (2) by means of LOCOS technique using the silicon nitride layer (5) as masking,

g) removal of the silicon nitride masking (5) and

h) uncovering and isolating from one another the active regions in the n-type tub regions (1) which require minimum isolation webs (8), by etching isolating troughs (10) in the oxide layer (4) after previously masking the p-type tub regions (2) and the remaining regions with a photoresist layer (9), a dry etching process first being carried out followed by a wet etching process.

2. Method according to Claim 1, the dry etching process in method step h) being carried out in trifluoromethane and oxygen (CHF₃ + O₂) and the wet etching process being carried out in buffered hydrofluoric acid.

## Revendications

1. Procédé pour fabriquer un circuit CMOS avec des zones de cuvettes (1, 2) continues dans un substrat (3) dopé p et présentant un type de conduction différent, comprenant les opérations suivantes:

a) réalisation de zones n de cuvettes dans le substrat (3) par implantation d'ions de phosphore ou d'arsenic, après masquage des autres zones du substrat (3) et diffusion des ions implantés,

b) exécution d'une oxydation (4) après enlèvement du masque d'implantation,

c) réalisation de zones p de cuvettes (2) par une implantation d'ions de bore par exemple, pour laquelle la dose et l'énergie sont choisies de manière que les zones p de cuvettes (2) présentent une plus faible profondeur de pénétration que les zones n de cuvettes (1),

d) dépôt de nitrure de silicium (5) sur toute la surface et structuration de cette couche de nitrure (5), de manière que les zones n de cuvettes (1) soient recouvertes à l'exception des zones des bords de cuvettes n chevauchant les zones p de cuvettes (2) et que les zones actives dans les zones p de cuvettes (2) soient définies par le fait que seules les régions dans lesquelles est effectuée l'implantation de champ (6) soient dégagées par gravure,

e) exécution de l'implantation de champ (6) avec des ions de bore,

f) réalisation des zones d'oxyde de champ (7) dans les zones p de cuvettes (2) et les zones des bords de cuvettes n chevauchant les zones p de cuvettes (2) par une technique LOCOS, avec utilisation de la couche de nitrure de silicium (5) en tant que masquage,

g) enlèvement du masquage formé par le nitrure de silicium (5) et

h) mise à nu et isolation mutuelle des zones actives dans les zones n de cuvettes (1), lesquelles demandent des barrettes d'isolation (8) minimales, par gravure de caissons de séparation (10) dans la couche d'oxyde (4), après masquage préalable des zones p de cuvettes (2) et des autres zones par une couche de laque photosensible (9), en exécutant d'abord un processus de gravure à sec et ensuite un processus de gravure par voie humide.

2. Procédé selon la revendication 1, dans lequel, pour l'opération h) on exécute le processus de gravure à sec dans le trifluorméthane et l'oxyde (CHF₃ + O₂) et on opère le processus de gravure par voie humide dans l'acide fluorhydrique tamponné.

FIG 1

FIG 2

FIG 3

FIG 4

FIG 5

FIG 6

FIG 7